# EUROPEAN PATENT SPECIFICATION

(11) **EP 1 964 144 B1**
(45) Date of publication and mention of the grant of the patent: **08.09.2010**
(21) Application number: 06846742.2
(22) Date of filing: 21.12.2006
(51) Int. Cl.: H01L 27/30, H01L 51/44, H01L 31/068

(54) **TANDEM PHOTOVOLTAIC CELLS**
PHOTOVOLTAISCHE TANDEMZELLEN
CELLULES PHOTOVOLTAÏQUES EN TANDEM

(30) Priority: 21.12.2005 US 752608 P; 11.04.2006 US 790606 P; 17.04.2006 US 792485 P
(43) Date of publication of application: 03.09.2008
(73) Proprietor: Konarka Technologies, Inc., Lowell, MA 01852 (US)
(72) Inventor: BRABEC, Christoph, A-4040 Linz (AT); GAUDIANA, Russell, Merrimack, New Hampshire 03054 (US); WALDAUF, Christoph, A-6020 Innsbruck (AT)
(74) Representative: Peterreins, Frank
(86) International application number: PCT/US2006/062459
(87) International publication number: WO 2007/076427

(56) References cited:
- EP-A- 1 065 725
- EP-A- 1 562 154
- WO-A-2004/042824
- DE-A1- 10 326 547
- US-A1- 2003 175 411
- US-A1- 2003 189 402
- US-B1- 6 188 175
- XUE JIANGENG ET AL: "Asymmetric tandem organic photovoltaic cells with hybrid planar-mixed molecular heterojunctions" APPLIED PHYSICS LETTERS, AIP, AMERICAN INSTITUTE OF PHYSICS, MELVILLE, NY, vol. 85, no. 23, 1 January 2004 (2004-01-01), pages 5757-5759, XP012063764 ISSN: 0003-6951
- YAMAGUCHI M ET AL: "Multi-junction III-V solar cells: current status and future potential" SOLAR ENERGY, PERGAMON PRESS. OXFORD, GB, vol. 79, no. 1, 1 July 2005 (2005-07-01), pages 78-85, XP004942373 ISSN: 0038-092X
- BJORSTROM ET AL.: 'Multilayer formation in spin-coated thin films of low-bandgap polyfluorene: PCBM blends' J. PHYSICS: CONDENS. MATER. 02 December 2005, pages L529 - L534

## Description

### TECHNICAL FIELD

The invention relates to tandem photovoltaic cells having a recombination layer, as well as related methods.

### BACKGROUND

Photovoltaic cells are commonly used to transfer energy in the form of light into energy in the form of electricity. A typical photovoltaic cell includes a photoactive material disposed between two electrodes. Generally, light passes through one or both of the electrodes to interact with the photoactive material to generate electricity. As a result, the ability of one or both of the electrodes to transmit light (e.g., light at one or more wavelengths absorbed by a photoactive material) can limit the overall efficiency of a photovoltaic cell. In many photovoltaic cells, a film of semiconductive material (e.g., indium tin oxide) is used to form the electrode(s) through which light passes because, although the semiconductive material may have a lower electrical conductivity than electrically conductive materials, the semiconductive material can transmit more light than many electrically conductive materials.

There is an increasing interest in the development of photovoltaic technology due primarily to a desire to reduce consumption of and dependency on fossil fuel-based energy sources. Photovoltaic technology is also viewed by many as being an environmentally friendly energy technology. However, for photovoltaic technology to be a commercially feasible energy technology, the material and manufacturing costs of a photovoltaic system (a system that uses one or more photovoltaic cells to convert light to electrical energy) should be recoverable over some reasonable time frame. But, in some instances the costs (e.g., due to materials and/or manufacture) associated with practically designed photovoltaic systems have restricted their availability and use.

DE 103 26 547 Al, which is regarded as closest prior art, relates to a solar cell comprising at least two photoactive layers. Solar cells or photovoltaic elements of this type are called tandem solar cells or photovoltaic multicells. Tandem cells are comprised, in essence, of an optical and electrical series connection of two photoactive layers. DE 103 26 547 A1 particularly relates to organic tandem solar cells that comprise at least one shared electrode, which is placed between two photo-voltaically active layers and which is made, in essence, of organic material.

The paper "Asymmetric tandem organic photovoltaic cells with hybrid planar-mixed molecular heterojunctions" by J. Xue et al., Applied Physics Letters, vol. 85, no. 23, 2004, pages 5757 to 5759, describes high-efficiency organic photovoltaic cells by stacking two hybrid planar-mixed molecular heterojunction cells in series. Absorption of incident light is maximized by locating the subcell tuned to absorb long-wavelength light nearest to the transparent anode, and tuning the second subcell closest to the reflecting metal cathode to preferentially absorb short-wavelength solar energy.

The paper "Multi-junction III-V solar cells: current status and future potential" by M. Yamaguchi et al., Solar Energy 79 (2005), pages 78 to 85, describes that conversion efficiency of InGaP/InGaAs/Ge has been improved up to 31 - 32 % (AM1.5) as a result of technologies development such as double hetero-wide band-gap tunnel junction, InGaP-Ge hetero-face structure bottom cell, and precise lattice-matching of InGaAs middle cell to Ge substrate by adding indium into the conventional GaAs layer.

WO 2004/042824 Al describes a method and a multijunction solar device having a high band gap heterojunction middle solar cell. In one example, a triple-junction solar device includes bottom, middle, and top cells. The bottom cell has a germanium substrate and a buffer layer, wherein the buffer layer is disposed over the Ge substrate. The middle cell contains a heterojunction structure, which further includes an emitter layer and a base layer that are disposed over the bottom cell. The top cell contains an emitter layer and a base layer disposed over the middle cell.

### SUMMARY

The invention relates to a photovoltaic tandem cell system according to claim 1 and a method for preparing the same according to claim 7. Preferred embodiments are described in the dependent claims.

In one aspect, this invention features a system that includes first and second electrodes, a recombination layer between the first and second electrodes, a first photoactive layer between the first electrode and the recombination layer, and a second photoactive layer between the second electrode and the recombination layer. The recombination layer includes a semiconductor material. The system is configured as a photovoltaic system.

In another aspect, this invention features a system that include first and second electrodes, first and second photoactive layers between the first and second electrodes, and a third layer between the first and second photoactive layers. The first photoactive layer includes a first semiconductor material and the second photoactive layer includes a second semiconductor material. The third layer includes a third semiconductor material different from the first or second semiconductor material. The system is configured as a photovoltaic system.

In another aspect, this invention features a system that includes first and second electrodes, first and second photoactive layers between the first and second electrodes, a third layer including an n-type semiconductor material, and a fourth layer include an p-type semiconductor material. The first photoactive layer is between the first electrode and the third layer, which is between the first and second photoactive layers. The second photoactive layer is between the second electrode and the fourth layer, which is between the second photoactive layer and the third layer. The system is configured as a photovoltaic system.

In another aspect, this invention features a system that includes first and second electrodes, a recombination layer between the first and second electrodes, a first photoactive layer between the first electrode and the recombination layer, and a second photoactive layer between the second electrode and the recombination layer. At least one of the first and second electrodes includes a mesh electrode. The recombination layer includes a semiconductor material. The system is configured as a photovoltaic system.

In still another aspect, this invention features a method that includes preparing a photovoltaic system having a recombination layer by a roll-to-roll process. Embodiments can include one or more of the following features.

The semiconductor material in the recombination layer includes a p-type semiconductor material and an n-type semiconductor material.

The p-type semiconductor material includes a polymer selected from the group consisting of polythiophenes (e.g., poly(3,4-ethylene dioxythiophene) (PEDOT)), polyanilines, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxalines, polybenzoisothiazoles, polybenzothiazoles, polythienothiophenes, poly(thienothiophene oxide)s, polydithienothiophenes, poly(dithienothiophene oxide)s, polytetrahydroisoindoles, and copolymers thereof.

In some embodiments, the p-type semiconductor material includes a metal oxide. For example, the metal oxide can include an oxide selected from the group consisting of copper oxides, strontium copper oxides, and strontium titanium oxides. In certain embodiments, the p-type semiconductor material includes a p-doped metal oxide (e.g., p-doped zinc oxides or p-doped titanium oxides).

The n-type semiconductor material includes a metal oxide. For example, the metal oxide can include an oxide selected from the group consisting of titanium oxides, zinc oxides, tungsten oxides, molybdenum oxides, and combinations thereof. In other embodiments, the n-type semiconductor material includes a material selected from the group consisting of fullerenes, inorganic nanoparticles, oxadiazoles, discotic liquid crystals, carbon nanorods, inorganic nanorods, polymers containing CN groups, polymers containing CF₃ groups, and combinations thereof.

In some embodiments, the recombination layer includes two layers, one layer including the p-type semiconductor material and the other layer including the n-type semiconductor material.

In some embodiments, the first or second photoactive layer includes an electron donor material and an electron acceptor material.

In some embodiments, the electron donor material includes a polymer selected from the group consisting of polythiophenes, polyanilines, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxaline, polybenzoisothiazole, polybenzothiazole, polythienothiophene, poly(thienothiophene oxide), polydithienothiophene, poly(dithienothiophene oxide)s, polytetrahydroisoindoles, and copolymers thereof. For example, the electron donor material can include a polymer selected from the group consisting of polythiophenes (e.g., poly(3-hexylthiophene) (P3HT)), polycyclopentadithiophenes (e.g., poly(cyclopentadithiophene-co-benzothiadiazole)), and copolymers thereof.

In some embodiments, the electron acceptor material includes a material selected from the group consisting of fullerenes, inorganic nanoparticles, oxadiazoles, discotic liquid crystals, carbon nanorods, inorganic nanorods, polymers containing CN groups, polymers containing CF₃ groups, and combinations thereof. For example, the electron acceptor material can include a substituted fullerene (e.g., C61-phenyl-butyric acid methyl ester (PCBM)).

In some embodiments, the first photoactive layer has a first band gap and the second photoactive layer has a second band gap different from the first band gap.

In some embodiments, the system further includes a hole carrier layer between the first photoactive layer and the first electrode. The hole carrier layer can include a polymer selected from the group consisting of polythiophenes, polyanilines, polyvinylcarbazoles, polyphenylenes, polyphenylvinylenes, polysilanes, polythienylenevinylenes, polyisothianaphthanenes, and copolymers thereof.

In some embodiments, the system further includes a hole blocking layer between the second photoactive layer and the second electrode. The hole blocking layer can include a material selected from the group consisting of LiF, metal oxides, and combinations thereof.

The system includes a tandem photovoltaic cell.

In some embodiments, the method further includes disposing the recombination layer onto a photoactive layer. The disposing can include disposing a first layer containing a first semiconductor material onto the photoactive layer and disposing a second layer containing a second semiconductor material different from the first semiconductor onto the first layer. In some embodiments, one of the first and second semiconductor materials is an n-type semiconductor material and the other of the first and second semiconductor materials is a p-type semiconductor material.

In some embodiments, the recombination layer is disposed on the photoactive layer using at least one process selected from the group consisting of solution coating, ink jet printing, spin coating, dip coating, knife coating, bar coating, spray coating, roller coating, slot coating, gravure coating, and screen printing.

Embodiments can provide one or more of the following advantages.

In some embodiments, the recombination layer can be prepared by using a solution process that can be readily used in a continuous roll-to-roll process. Such a process can significantly reduce the cost of preparing a photovoltaic cell.

In some embodiments, the photoactive layer can include a low band gap electron donor material, such as a polymer having an absorption wavelength at the red and near IR regions (e.g., 650 - 800 nm) of the electromagnetic spectrum, which is not accessible by most other conventional polymers. When such a polymer is incorporated into a photovoltaic cell together with a conventional polymer, it enables the cell to absorb the light in this region of the spectrum, thereby increasing the current and efficiency of the cell.

In some embodiments, the first and second photoactive layers have different band gaps. Thus, light not absorbed by one photoactive layer can be absorbed by another photoactive layer, thereby increasing the efficiency of the photovoltaic cell.

The details of one or more embodiments of the invention are set forth in the accompanying drawings and the description below. Other features and advantages of the invention will be apparent from the description and drawings, and from the claims.

### DESCRIPTION OF DRAWINGS

FIG. 1 is a cross-sectional view of an embodiment of a tandem photovoltaic cell.
FIG. 2 is an elevational view of an embodiment of a mesh electrode.
FIG. 3 is a cross-sectional view of the mesh electrode of FIG. 2.
FIG. 4 is a cross-sectional view of another embodiment of a tandem photovoltaic cell.

Like reference symbols in the various drawings indicate like elements.

### DETAILED DESCRIPTION

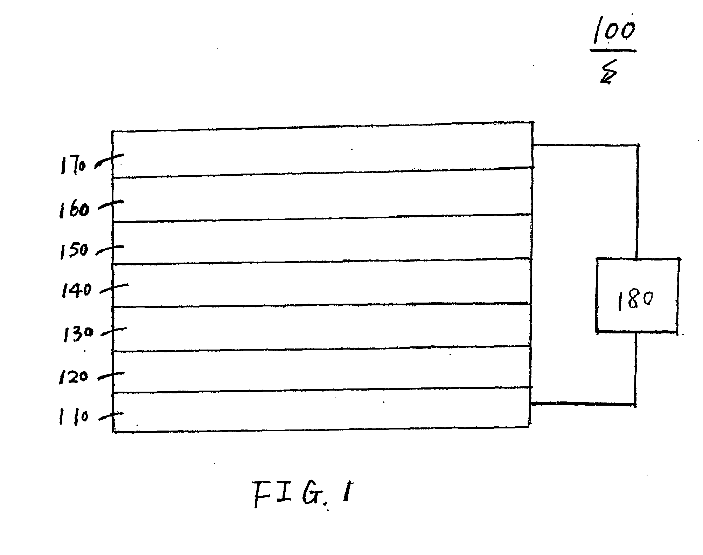

FIG. 1 shows a tandem photovoltaic cell 100 having a cathode 110, a hole carrier layer 120, a photoactive layer 130, a recombination layer 140, a photoactive layer 150, a hole blocking layer 160, an anode 170, and an external load 180 connected to photovoltaic cell 100 via cathode 110 and anode 170.

In general, a recombination layer refers to a layer in a tandem cell where the electrons generated from a first cell recombine with the holes generated from a second cell. Recombination layer 140 typically includes a p-type semiconductor material and an n-type semiconductor material. In general, n-type semiconductor materials selectively transport electrons and p-type semiconductor materials selectively transport holes. As a result, electrons generated from the first cell recombine with holes generated from the second cell at the interface of the n-type and p-type semiconductor materials.

In some embodiments, the p-type semiconductor material includes a polymer and/or a metal oxide. Examples p-type semiconductor polymers include polythiophenes (e.g., poly(3,4-ethylene dioxythiophene) (PEDOT)), polyanilines, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxaline, polybenzoisothiazole, polybenzothiazole, polythienothiophene, poly(thienothiophene oxide), polydithienothiophene, poly(dithienothiophene oxide)s, polytetrahydroisoindoles, and copolymers thereof. The metal oxide can be an intrinsic p-type semiconductor (e.g., copper oxides, strontium copper oxides, or strontium titanium oxides) or a metal oxide that forms a p-type semiconductor after doping with a dopant (e.g., p-doped zinc oxides or p-doped titanium oxides). Examples of dopants includes salts or acids of fluoride, chloride, bromide, and iodide. In some embodiments, the metal oxide can be used in the form of nanoparticles.

In some embodiments, the n-type semiconductor material includes a metal oxide, such as titanium oxides, zinc oxides, tungsten oxides, molybdenum oxides, and combinations thereof. The metal oxide can be used in the form of nanoparticles. In other embodiments, the n-type semiconductor material includes a material selected from the group consisting of fullerenes, inorganic nanoparticles, oxadiazoles, discotic liquid crystals, carbon nanorods, inorganic nanorods, polymers containing CN groups, polymers containing CF₃ groups, and combinations thereof.

In some embodiments, the p-type and n-type semiconductor materials are blended into one layer. In certain embodiments, the recombination layer includes two layers, one layer including the p-type semiconductor material and the other layer including the n-type semiconductor material.

In some embodiments, recombination layer 140 includes at least about 30 wt% (e.g., at least about 40 wt% or at least about 50 wt%) and/or at most about 70 wt% (e.g., at most about 60 wt% or at most about 50 wt%) of the p-type semiconductor material. In some embodiments, recombination layer 140 includes at least about 30 wt% (e.g., at least about 40 wt% or at least about 50 wt%) and/or at most about 70 wt% (e.g., at most about 60 wt% or at most about 50 wt%) of the n-type semiconductor material.

Recombination layer 140 generally has a sufficient thickness so that the layers underneath are protected from any solvent applied onto recombination layer 140. In some embodiments, recombination layer 140 can have a thickness at least about 10 nm (e.g., at least about 20 nm, at least about 50 nm, or at least about 100 nm) and/or at most about 500 nm (e.g., at most about 200 nm, at most about 150 nm, or at most about 100 nm).

In general, recombination layer 140 is substantially transparent. For example, at the thickness used in a tandem photovoltaic cell 100, recombination layer 140 can transmit at least about 70% (e.g., at least about 75%, at least about 80%, at least about 85%, or at least about 90%) of incident light at a wavelength or a range of wavelengths (e.g., from about 350 nm to about 1,000 nm) used during operation of the photovoltaic cell.

Recombination layer 140 generally has a sufficiently low resistivity. In some embodiments, recombination layer 140 has a resistivity of at most about 1 x 10⁵ ohm/square, (e.g., at most about 2 x 10⁵ ohm/square, at most about 5 x 10⁵ ohm/square, or at most about 1 x 10⁶ ohm/square).

Without wishing to be bound by theory, it is believed that recombination layer 140 can be considered as a common electrode between two sub-cells (one including cathode 110, hole carrier layer 120, and photoactive layer 130, and the other include photoactive layer 150, hole blocking layer 160, and anode 170) in photovoltaic cells 100.

Cathode 110 is generally formed of an electrically conductive material. Examples of electrically conductive materials include electrically conductive metals, electrically conductive alloys, and electrically conductive polymers. Exemplary electrically conductive metals include gold, silver, copper, aluminum, nickel, palladium, platinum and titanium. Exemplary electrically conductive alloys include stainless steel (e.g., 332 stainless steel, 316 stainless steel), alloys of gold, alloys of silver, alloys of copper, alloys of aluminum, alloys of nickel, alloys of palladium, alloys of platinum and alloys of titanium. Exemplary electrically conducting polymers include polythiophenes (e.g., PEDOT), polyanilines (e.g., doped polyanilines), polypyrroles (e.g., doped polypyrroles). In some embodiments, combinations of electrically conductive materials are used.

In some embodiments, cathode 110 can include a mesh electrode. Examples of mesh electrodes are described in commonly owned co-pending U.S. Patent Application Publication Nos. 20040187911 and 20060090791.

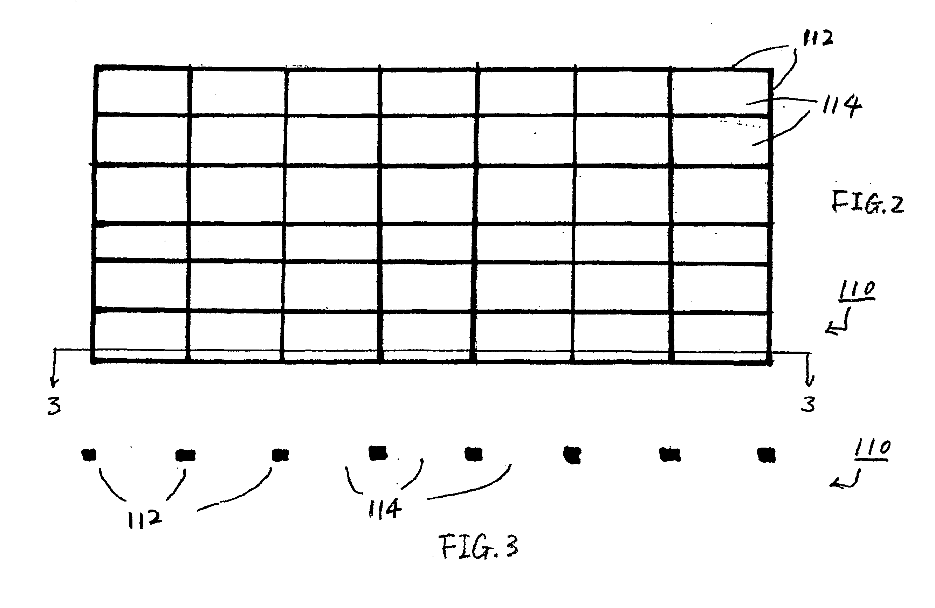

FIGs. 2 and 3 shows a mesh cathode 110 that includes solid regions 112 and open regions 114. In general, regions 112 are formed of electrically conducting material so that mesh cathode 110 can allow light to pass therethrough via regions 114 and conduct electrons via regions 112.

The area of mesh cathode 110 occupied by open regions 114 (the open area of mesh cathode 110) can be selected as desired. Generally, the open area of mesh cathode 110 is at least about 10% (e.g., at least about 20%, at least about 30%, at least about 40%, at least about 50%, at least about 60%, at least about 70%, at least about 80%) and/or at most about 99% (e.g., at most about 95%, at most about 90%, at most about 85%) of the total area of mesh cathode 110.

Mesh cathode 110 can be prepared in various ways. In some embodiments, mesh cathode 110 is a woven mesh formed by weaving wires of material that form solid regions 112. The wires can be woven using, for example, a plain weave, a Dutch, weave, a twill weave, a Dutch twill weave, or combinations thereof. In certain embodiments, mesh cathode 110 is formed of a welded wire mesh. In some embodiments, mesh cathode 110 is an expanded mesh formed. An expanded metal mesh can be prepared, for example, by removing regions 114 (e.g., via laser removal, via chemical etching, via puncturing) from a sheet of material (e.g., an electrically conductive material, such as a metal), followed by stretching the sheet (e.g., stretching the sheet in two dimensions). In certain embodiments, mesh cathode 110 is a metal sheet formed by removing regions 114 (e.g., via laser removal, via chemical etching, via puncturing) without subsequently stretching the sheet.

In certain embodiments, solid regions 112 are formed entirely of an electrically conductive material (e.g., regions 112 are formed of a substantially homogeneous material that is electrically conductive), such as those described above. In some embodiments, solid regions 112 can have a resistivity less than about 3 ohm per square.

In some embodiments, solid regions 112 are formed of a first material that is coated with a second material different from the first material (e.g., using metallization, using vapor deposition). In general, the first material can be formed of any desired material (e.g., an electrically insulative material, an electrically conductive material, or a semiconductive material), and the second material is an electrically conductive material. Examples of electrically insulative material from which the first material can be formed include textiles, optical fiber materials, polymeric materials (e.g., a nylon) and natural materials (e.g., flax, cotton, wool, silk). Examples of electrically conductive materials from which the first material can be formed include the electrically conductive materials disclosed above. Examples of semiconductive materials from which the first material can be formed include indium tin oxide, fluorinated tin oxide, tin oxide and zinc oxide. In some embodiments, the first material is in the form of a fiber, and the second material is an electrically conductive material that is coated on the first material. In certain embodiments, the first material is in the form of a mesh (see discussion above) that, after being formed into a mesh, is coated with the second material. As an example, the first material can be an expanded metal mesh, and the second material can be PEDOT that is coated on the expanded metal mesh.

Generally, the maximum thickness of mesh cathode 110 should be less than the total thickness of hole carrier layer 120. Typically, the maximum thickness of mesh cathode 110 is at least 0.1 micron (e.g., at least about 0.2 micron, at least about 0.3 micron, at least about 0.4 micron, at least about 0.5 micron, at least about 0.6 micron, at least about 0.7 micron, at least about 0.8 micron, at least about 0.9 micron, at least about one micron) and/or at most about 10 microns (e.g., at most about nine microns, at most about eight microns, at most about seven microns, at most about six microns, at most about five microns, at most about four microns, at most about three microns, at most about two microns).

While shown in FIG. 2 as having a rectangular shape, open regions 114 can generally have any desired shape (e.g., square, circle, semicircle, triangle, diamond, ellipse, trapezoid, irregular shape). In some embodiments, different open regions 114 in mesh cathode 110 can have different shapes.

Although shown in FIG. 3 as having square cross-sectional shape, solid regions 112 can generally have any desired shape (e.g., rectangle, circle, semicircle, triangle, diamond, ellipse, trapezoid, irregular shape). In some embodiments, different solid regions 112 in mesh cathode 110 can have different shapes. In embodiments where solid regions 112 have a circular cross-section, the cross-section can have a diameter in the range of about 5 microns to about 200 microns. In embodiments where solid regions 112 have a trapezoid cross-section, the cross-section can have a height in the range of about 0.1 micron to about 5 microns and a width in the range of about 5 microns to about 200 microns.

In some embodiments, mesh cathode 110 is flexible (e.g., sufficiently flexible to be incorporated in photovoltaic cell 100 using a continuous, roll-to-roll manufacturing process). In certain embodiments, mesh cathode 110 is semi-rigid or inflexible. In some embodiments, different regions of mesh cathode 110 can be flexible, semi-rigid or inflexible (e.g., one or more regions flexible and one or more different regions semi-rigid, one or more regions flexible and one or more different regions inflexible).

In general, mesh electrode 110 can be disposed on a substrate. In some embodiments, mesh electrode 110 can be partially embedded in the substrate.

Hole carrier layer 120 is generally formed of a material that, at the thickness used in photovoltaic cell 100, transports holes to cathode 110 and substantially blocks the transport of electrons to cathode 110. Examples of materials from which layer 120 can be formed include polythiophenes (e.g., PEDOT), polyanilines, polyvinylcarbazoles, polyphenylenes, polyphenylvinylenes, polysilanes, polythienylenevinylenes, polyisothianaphthanenes, and copolymers thereof. In some embodiments, hole carrier layer 120 can include combinations of hole carrier materials.

In general, the thickness of hole carrier layer 120 (i.e., the distance between the surface of hole carrier layer 120 in contact with first photoactive layer 130 and the surface of cathode 110 in contact with hole carrier layer 120) can be varied as desired. Typically, the thickness of hole carrier layer 120 is at least 0.01 micron (e.g., at least about 0.05 micron, at least about 0.1 micron, at least about 0.2 micron, at least about 0.3 micron, or at least about 0.5 micron) and/or at most about five microns (e.g., at most about three microns, at most about two microns, or at most about one micron). In some embodiments, the thickness of hole carrier layer 120 is from about 0.01 micron to about 0.5 micron.

Each of photoactive layers 130 and 150 generally contains an electron acceptor material and an electron donor material.

Examples of electron acceptor materials include fullerenes, oxadiazoles, carbon nanorods, discotic liquid crystals, inorganic nanoparticles (e.g., nanoparticles formed of zinc oxide, tungsten oxide, indium phosphide, cadmium selenide and/or lead sulphide), inorganic nanorods (e.g., nanorods formed of zinc oxide, tungsten oxide, indium phosphide, cadmium selenide and/or lead sulphide), or polymers containing moieties capable of accepting electrons or forming stable anions (e.g., polymers containing CN groups, polymers containing CF₃ groups). In some embodiments, the electron acceptor material is a substituted fullerene (e.g., PCBM). In some embodiments, a combination of electron acceptor materials can be used in photoactive layer 130 or 150.

Examples of electron donor materials include conjugated polymers, such as polythiophenes, polyanilines, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxalines, polybenzoisothiazoles, polybenzothiazoles, polythienothiophenes, poly(thienothiophene oxide)s, polydithienothiophenes, poly(dithienothiophene oxide)s, polytetrahydroisoindoles, and copolymers thereof. In some embodiments, the electron donor material can be polythiophenes (e.g., poly(3-hexylthiophene)), polycyclopentadithiophenes, and copolymers thereof. In certain embodiments, a combination of electron donor materials can be used in photoactive layer 130 or 150.

In some embodiments, the electron donor materials or the electron acceptor materials can include a polymer having a first comonomer repeat unit and a second comonomer repeat unit different from the first comonomer repeat unit. The first comonomer repeat unit can include a cyclopentadithiophene moiety, a silacyclopentadithiophene moiety, a cyclopentadithiazole moiety, a thiazolothiazole moiety, a thiazole moiety, a benzothiadiazole moiety, a thiophene oxide moiety, a cyclopentadithiophene oxide moiety, a polythiadiazoloquinoxaline moiety, a benzoisothiazole moiety, a benzothiazole moiety, a thienothiophene moiety, a thienothiophene oxide moiety, a dithienothiophene moiety, a dithienothiophene oxide moiety, or a tetrahydroisoindoles moiety.

In some embodiments, the first comonomer repeat unit includes a cyclopentadithiophene moiety. In some embodiments, the cyclopentadithiophene moiety is substituted with at least one substituent selected from the group consisting of C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, and SO₂R; R being H, C₁-C₂₀ alkyl, C₁-C₂₀ alkoxy, aryl, heteroaryl, C₃-C₂₀ cycloalkyl, or C₁-C₂₀ heterocycloalkyl. For example, the cyclopentadithiophene moiety can be substituted with hexyl, 2-ethylhexyl, or 3,7-dimethyloctyl. In certain embodiments, the cyclopentadithiophene moiety is substituted at 4-position. In some embodiments, the first comonomer repeat unit can include a cyclopentadithiophene moiety of formula (1): 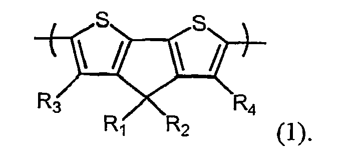 In formula (1), each of H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R; R being H, C₁-C₂₀ alkyl, C₁-C₂₀ alkoxy, aryl, heteroaryl, C₃-C₂₀ cycloalkyl, or C₁-C₂₀ heterocycloalkyl. For example, each of R₁ and R₂, independently, can be hexyl, 2-ethylhexyl, or 3,7-dimethyloctyl.

An alkyl can be saturated or unsaturated and branch or straight chained. A C₁-C₂₀ alkyl contains 1 to 20 carbon atoms (e.g., one, two , three, four, five, six, seven, eight, nine, 10, 11, 12, 13, 14, 15, 16, 17, 18, 19, and 20 carbon atoms). Examples of alkyl moieties include -CH₃, -CH₂-, -CH₂=CH₂-, -CH₂-CH=CH₂, and branched -C₃H₇. An alkoxy can be branch or straight chained and saturated or unsaturated. An C₁-C₂₀ alkoxy contains an oxygen radical and 1 to 20 carbon atoms (e.g., one, two , three, four, five, six, seven, eight, nine, 10, 11, 12, 13, 14, 15, 16, 17, 18, 19, and 20 carbon atoms). Examples of alkoxy moieties include -OCH₃ and -OCH=CH-CH₃. A cycloalkyl can be either saturated or unsaturated. A C₃-C₂₀ cycloalkyl contains 3 to 20 carbon atoms (e.g., three, four, five, six, seven, eight, nine, 10, 11, 12, 13, 14, 15, 16, 17, 18, 19, and 20 carbon atoms). Examples of cycloalkyl moieities include cyclohexyl and cyclohexen-3-yl. A heterocycloalkyl can also be either saturated or unsaturated. A C₃-C₂₀ heterocycloalkyl contains at least one ring heteroatom (e.g., O, N, and S) and 3 to 20 carbon atoms (e.g., three, four, five, six, seven, eight, nine, 10, 11, 12, 13, 14, 15, 16, 17, 18, 19, and 20 carbon atoms). Examples of heterocycloalkyl moieties include 4-tetrahydropyranyl and 4-pyranyl. An aryl can contain one or more aromatic rings. Examples of aryl moieties include phenyl, phenylene, naphthyl, naphthylene, pyrenyl, anthryl, and phenanthryl. A heteroaryl can contain one or more aromatic rings, at least one of which contains at least one ring heteroatom (e.g., O, N, and S). Examples of heteroaryl moieties include furyl, furylene, fluorenyl, pyrrolyl, thienyl, oxazolyl, imidazolyl, thiazolyl, pyridyl, pyrimidinyl, quinazolinyl, quinolyl, isoquinolyl, and indolyl.

Alkyl, alkoxy, cycloalkyl, heterocycloalkyl, aryl, and heteroaryl mentioned herein include both substituted and unsubstituted moieties, unless specified otherwise. Examples of substituents on cycloalkyl, heterocycloalkyl, aryl, and heteroaryl include C₁-C₂₀ alkyl, C₃-C₂₀ cycloalkyl, C₁-C₂₀ alkoxy, aryl, aryloxy, heteroaryl, heteroaryloxy, amino, C₁-C₁₀ alkylamino, C₁-C₂₀ dialkylamino, arylamino, diarylamino, hydroxyl, halogen, thio, C₁-C₁₀ alkylthio, arylthio, C₁-C₁₀ alkylsulfonyl, arylsulfonyl, cyano, nitro, acyl, acyloxy, carboxyl, and carboxylic ester. Examples of substituents on alkyl include all of the above-recited substituents except C₁-C₂₀ alkyl. Cycloalkyl, heterocycloalkyl, aryl, and heteroaryl also include fused groups.

The second comonomer repeat unit can include a benzothiadiazole moiety, a thiadiazoloquinoxaline moiety, a cyclopentadithiophene oxide moiety, a benzoisothiazole moiety, a benzothiazole moiety, a thiophene oxide moiety, a thienothiophene moiety, a thienothiophene oxide moiety, a dithienothiophene moiety, a dithienothiophene oxide moiety, a tetrahydroisoindole moiety, a fluorene moiety, a silole moiety, a cyclopentadithiophene moiety, a fluorenone moiety, a thiazole moiety, a selenophene moiety, a thiazolothiazole moiety, a cyclopentadithiazole moiety, a naphthothiadiazole moiety, a thienopyrazine moiety, a silacyclopentadithiophene moiety, an oxazole moiety, an imidazole moiety, a pyrimidine moiety, a benzoxazole moiety, or a benzimidazole moiety. In some embodiments, the second comonomer repeat unit is a 3,4-benzo-1,2,5-thiadiazole moiety.

In some embodiments, the second comonomer repeat unit can include a benzothiadiazole moiety of formula (2), a thiadiazoloquinoxaline moiety of formula (3), a cyclopentadithiophene dioxide moiety of formula (4), a cyclopentadithiophene monoxide moiety of formula (5), a benzoisothiazole moiety of formula (6), a benzothiazole moiety of formula (7), a thiophene dioxide moiety of formula (8), a cyclopentadithiophene dioxide moiety of formula (9), a cyclopentadithiophene tetraoxide moiety of formula (10), a thienothiophene moiety of formula (11), a thienothiophene tetraoxide moiety of formula (12), a dithienothiophene moiety of formula (13), a dithienothiophene dioxide moiety of formula (14), a dithienothiophene tetraoxide moiety of formula (15), a tetrahydroisoindole moiety of formula (16), a thienothiophene dioxide moiety of formula (17), a dithienothiophene dioxide moiety of formula (18), a fluorene moiety of formula (19), a silole moiety of formula (20), a cyclopentadithiophene moiety of formula (21), a fluorenone moiety of formula (22), a thiazole moiety of formula (23), a selenophene moiety of formula (24), a thiazolothiazole moiety of formula (25), a cyclopentadithiazole moiety of formula (26), a naphthothiadiazole moiety of formula (27), a thienopyrazine moiety of formula (28), a silacyclopentadithiophene moiety of formula (29), an oxazole moiety of formula (30), an imidazole moiety of formula (31), a pyrimidine moiety of formula (32), a benzoxazole moiety of formula (33), or a benzimidazole moiety of formula (34): 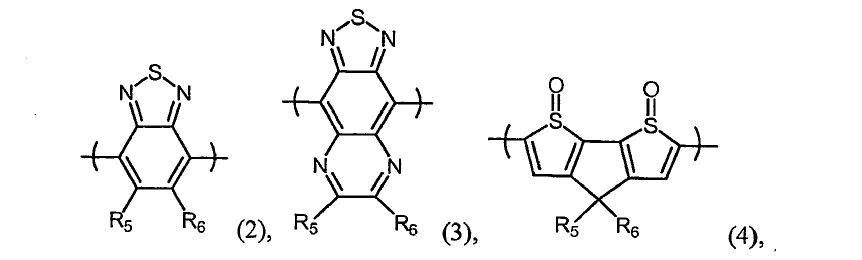 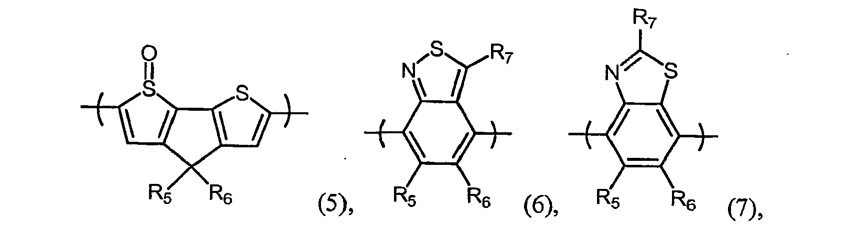 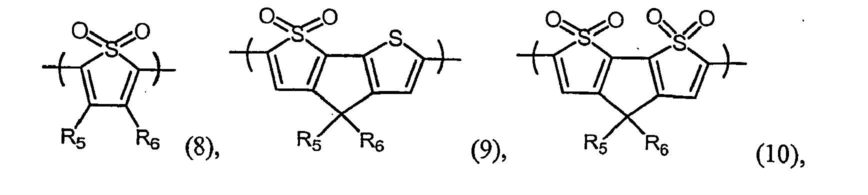 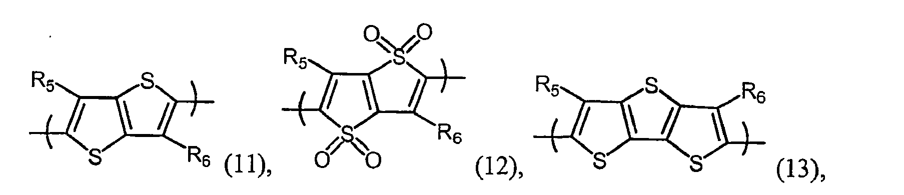 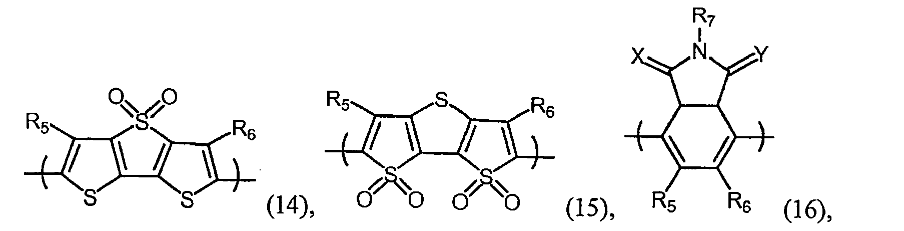 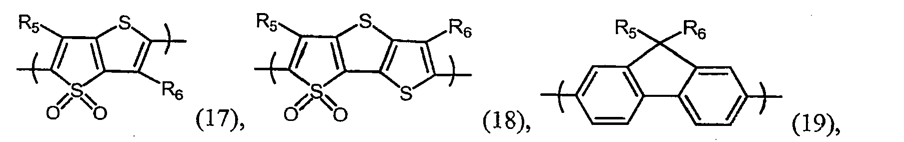 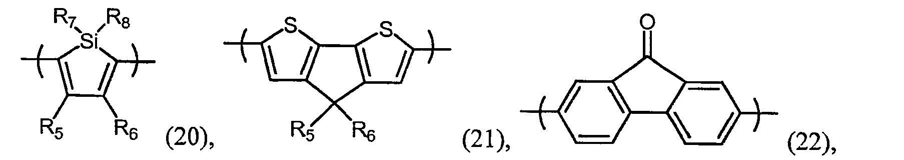 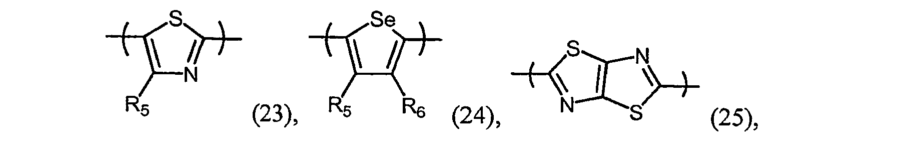 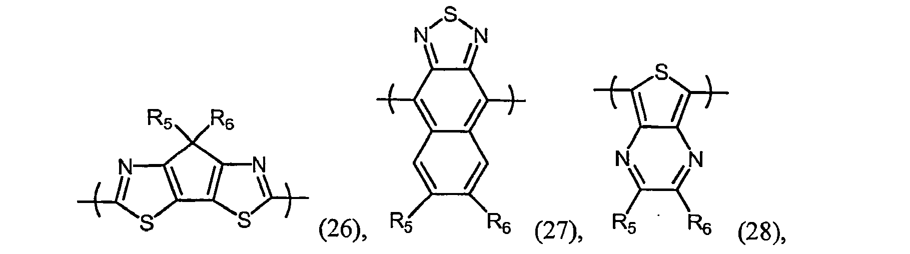 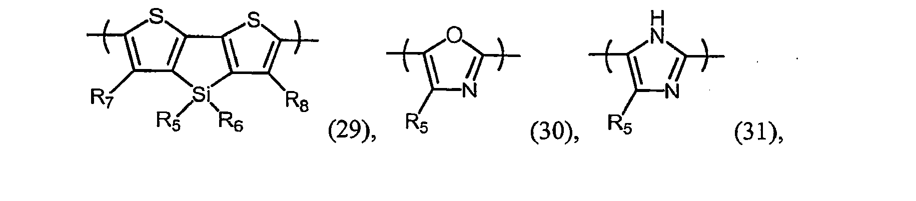 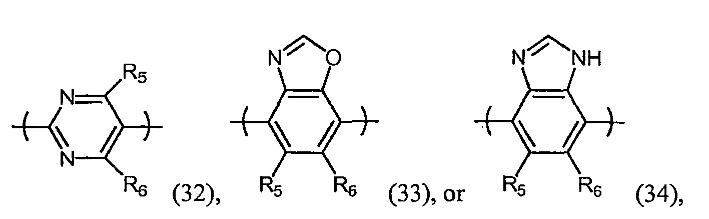 In the above formulas, each of X and Y, independently, is CH₂, O, or S; each of R₅ and R₆, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R, in which R is H, C₁-C₂₀ alkyl, C₁-C₂₀ alkoxy, aryl, heteroaryl, C₃-C₂₀ cycloalkyl, or C₁-C₂₀ heterocycloalkyl; and each of R₇ and R₈, independently, is H, C₁-C₂₀ alkyl, C₁-C₂₀ alkoxy, aryl, heteroaryl, C₃-C₂₀ cycloalkyl, or C₃-C₂₀ heterocycloalkyl. In some embodiments, the second comonomer repeat unit includes a benzothiadiazole moiety of formula (2), in which each of R₅ and R₆ is H.

The second comonomer repeat unit can include at least three thiophene moieties. In some embodiments, at least one of the thiophene moieties is substituted with at least one substituent selected from the group consisting of C₁-C₂₀ alkyl, C₁-C₂₀ alkoxy, aryl, heteroaryl, C₃-C₂₀ cycloalkyl, and C₃-C₂₀ heterocycloalkyl. In certain embodiments, the second comonomer repeat unit includes five thiophene moieties.

The polymer can further include a third comonomer repeat unit that contains a thiophene moiety or a fluorene moiety. In some embodiments, the thiophene or fluorene moiety is substituted with at least one substituent selected from the group consisting of C₁-C₂₀ alkyl, C₁-C₂₀ alkoxy, aryl, heteroaryl, C₃-C₂₀ cycloalkyl, and C₃-C₂₀ heterocycloalkyl.

In some embodiments, the polymer can be formed by any combination of the first, second, and third comonomer repeat units. In certain embodiments, the polymer can be a homopolymer containing any of the first, second, and third comonomer repeat units.

In some embodiments, the polymer can be 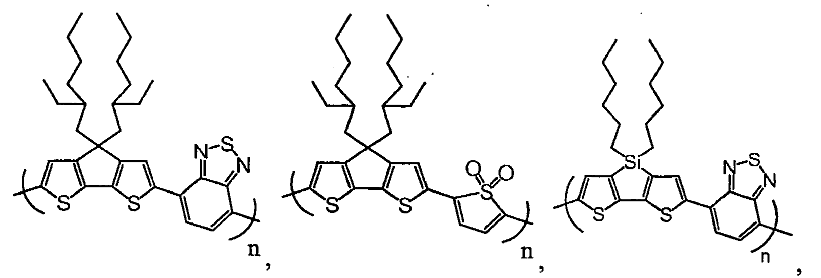 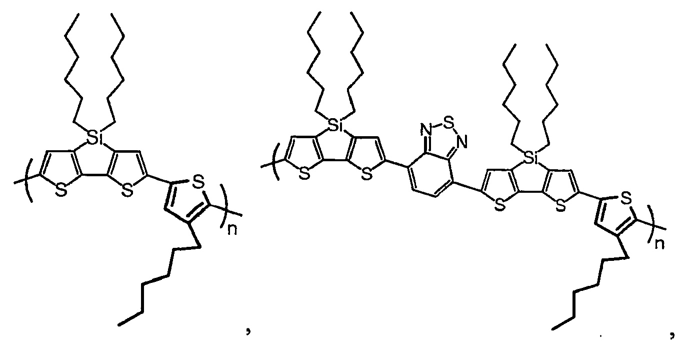 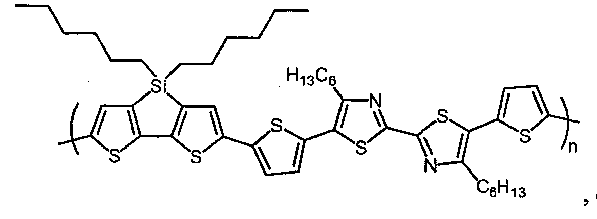 or 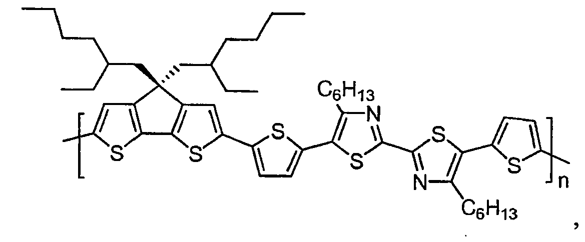 in which n can be an integer greater than 1.

The monomers for preparing the polymers mentioned herein may contain a nonaromatic double bond and one or more asymmetric centers. Thus, they can occur as racemates and racemic mixtures, single enantiomers, individual diastereomers, diastereomeric mixtures, and cis- or trans- isomeric forms. All such isomeric forms are contemplated.

The polymers described above can be prepared by methods known in the art, such as those described in commonly owned co-pending U.S. Application No 11/601,374. For example, a copolymer can be prepared by a cross-coupling reaction between one or more comonomers containing two alkylstannyl groups and one or more comonomers containing two halo groups in the presence of a transition metal catalyst. As another example, a copolymer can be prepared by a cross-coupling reaction between one or more comonomers containing two borate groups and one or more comonomers containing two halo groups in the presence of a transition metal catalyst. The comonomers can be prepared by the methods described herein or by the methods know in the art, such as those described in U.S. Patent Application Serial No. 11/486,536, Coppo et al., Macromolecules 2003, 36, 2705-2711 and Kurt et al., J. Heterocycl. Chem. 1970, 6, 629.

Without wishing to be bound by theory, it is believed that an advantage of the polymers described above is that their absorption wavelengths shift toward the red and near IR regions (e.g., 650 - 800 nm) of the electromagnetic spectrum, which is not accessible by most other conventional polymers. When such a polymer is incorporated into a photovoltaic cell together with a conventional polymer, it enables the cell to absorb the light in this region of the spectrum, thereby increasing the current and efficiency of the cell.

In some embodiments, photoactive layer 130 has a first band gap and photoactive layer 150 has a second band gap different from the first band gap. In such embodiments, light not absorbed by one photoactive layer can be absorbed by another photoactive layer, thereby increasing the efficiency of photovoltaic cell 100.

Generally, photoactive layer 130 or 150 is sufficiently thick to be relatively efficient at absorbing photons impinging thereon to form corresponding electrons and holes, and sufficiently thin to be relatively efficient at transporting the holes and electrons. In certain embodiments, photoactive layer 130 or 150 is at least 0.05 micron (e.g., at least about 0.1 micron, at least about 0.2 micron, at least about 0.3 micron) thick and/or at most about one micron (e.g., at most about 0.5 micron, at most about 0.4 micron) thick. In some embodiments, photoactive layer 130 or 150 is from about 0.1 micron to about 0.2 micron thick.

In general, photoactive layer 130 or 150 can be formed by using a suitable process, such as solution coating, ink jet printing, spin coating, dip coating, knife coating, bar coating, spray coating, roller coating, slot coating, gravure coating, or screen printing.

Hole blocking layer 160 is generally formed of a material that, at the thickness used in photovoltaic cell 100, transports electrons to anode 170 and substantially blocks the transport of holes to anode 170. Examples of materials from which hole blocking layer 160 can be formed include LiF and metal oxides (e.g., zinc oxide, titanium oxide).

Typically, hole blocking layer 160 is at least 0.02 micron (e.g., at least about 0.03 micron, at least about 0.04 micron, at least about 0.05 micron) thick and/or at most about 0.5 micron (e.g., at most about 0.4 micron, at most about 0.3 micron, at most about 0.2 micron, at most about 0.1 micron) thick.

Anode 170 is generally formed of an electrically conductive material, such as one or more of the electrically conductive materials noted above. In some embodiments, anode 170 is formed of a combination of electrically conductive materials. In certain embodiments, anode 170 can be formed of a mesh electrode.

Without wishing to be bound by theory, it is believed that tandem photovoltaic cell 100 achieves the highest efficiency when photoactive layers 130 and 150 generate substantially the same amount of current.

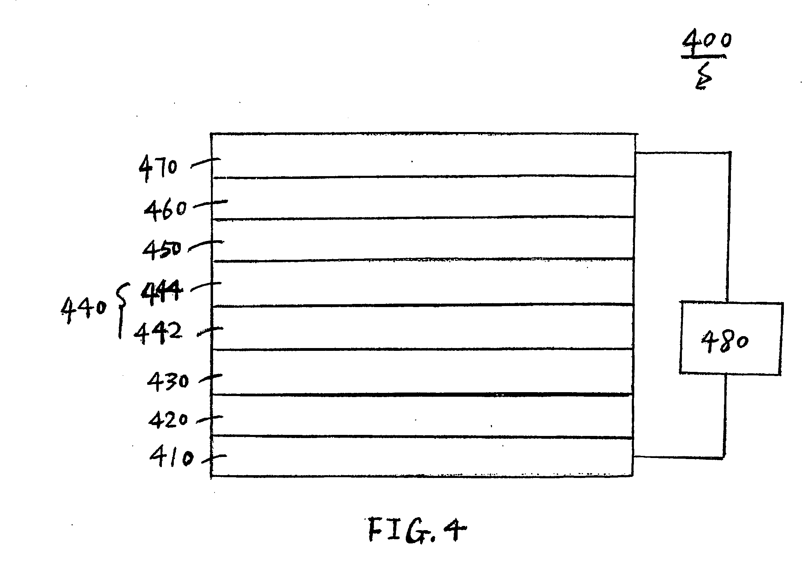

FIG. 4 shows a tandem photovoltaic cell 400 having a cathode 410, a hole carrier layer 420, a photoactive layer 430, a recombination layer 440, a photoactive layer 450, a hole blocking layer 460, an anode 470, and an external load 480 connected to photovoltaic cell 400 via cathode 410 and anode 470. Recombination layer 440 includes a layer 442 that contains an an-type semiconductor material and a layer 444 that contains a p-type semiconductor material. In some embodiments, recombination layer 440 can include a layer of mixed n-type and p-type semiconductor material at the interface of layer 442 and layer 444.

In some embodiments, a two-layer recombination layer can be prepared by applying a layer of an n-type semiconductor material and a layer of a p-type semiconductor material separately. For example, when titanium oxide nanoparticles are used as an n-type semiconductor material, a layer of titanium oxide nanoparticles can be formed by (1) dispersing a precursor (e.g., a titanium salt) in a solvent (e.g., an anhydrous alcohol) to form a dispersion, (2) coating the dispersion on a photoactive layer, (3) hydrolyzing the dispersion to form a titanium oxide layer, and (4) drying the titanium oxide layer. As another example, when a polymer (e.g., PEDOT) is used a p-type semiconductor, a polymer layer can be formed by first dissolving the polymer in a solvent (e.g., an anhydrous alcohol) to form a solution and then coating the solution on a photoactive layer. In some embodiments, a one-layer recombination layer can be prepared by applying a blend of an n-type semiconductor material and a p-type semiconductor material on photoactive layer. For example, an n-type semiconductor and a p-type semiconductor can be first dispersed and/or dissolved in a solvent together to form a dispersion or solution and then coated the dispersion or solution on a photoactive layer to form a recombination layer. The coating process mentioned above can be achieved by using at least one process selected from the group consisting of solution coating, ink jet printing, spin coating, dip coating, knife coating, bar coating, spray coating, roller coating, slot coating, gravure coating, and screen printing.

Without wishing to bound by theory, it is believed that the solution process described above can be readily used in a continuous manufacturing process, such as a roll-to-roll process, thereby significantly reducing the cost of preparing a photovoltaic cell. Examples of roll-to-roll processes have been described in, for example, U.S. Application Publication No. 2005-0263179.

The following examples are illustrative and not intended to be limiting.

### Example 1:

A tandem photovoltaic cell having the structure of ITO/TiO₂/ P3HT:PCBM/ PEDOT/TiO2/P3HT:PCBM/PEDOT/Ag was prepared as follows. A substrate with ITO (having a resistivity of 13 ohm/square) was cleaned sequentially with acetone and isopropanol for 10 minutes in an ultrasonic bath at room temperature. Tetra-n-butyl-titanate (TYZOR; E. I. du Pont de Nemours and Company, Wilmington, DE) diluted 1:199 in anhydrous isopropanol was applied onto the ITO via doctor-blading (40 mm/s; 600 µm slot at 40°C) and hydrolyzed by distilled water. The coating thus obtained was dried for 10 minutes to give a titanium oxide layer having a thickness of 10 ± 5 nm. A solution ofpoly-(3-hexylthiophen) (P3HT): C61-phenyl-butyric acid methyl ester (PCBM) in ortho-xylene (1.5 mg: 1.2 mg:100 µl) was then applied onto the titanium oxide layer via doctor-blading (7.5 mm/s; 600 µm slot at 65°C) to give a P3HT:PCBM layer having a thickness of 100 ± 10 nm. A solution of PEDOT in isopropanol (1 ml:5 ml) was subsequently coated on the P3HT:PCBM layer via doctor-blading (2 x 5 mm/s; 150 µm slot at 85°C) to give in a PEDOT layer of 30 ± 10 nm. After the device thus obtained was baked for 10 minutes at 140°C in nitrogen atmosphere, tetra-n-butyl-titanate diluted 1:199 in anhydrous isopropanol was applied onto the PEDOT layer via doctor-blading (40 mm/s; 600 µm slot at 40°C). The coating was hydrolyzed and dried for 10 minutes to give a second titanium oxide layer of 10 ± 5 nm. The PEDOT layer and the second titanium oxide layer obtained above constituted as the recombination layer in the final tandem photovoltaic cell. A solution of P3HT:PCBM in ortho-xylene (1.5 mg: 1.2 mg:100 µl) was then applied onto the second titanium oxide layer via doctor-blading (65 mm/s; 600 µm slot at 65°C) to give a second P3HT:PCBM layer having a thickness of 300 ± 30 nm. Subsequently, a solution of PEDOT in isopropanol (1 ml:5 ml) was applied onto the second P3HT:PCBM layer via doctor-blading (2 x 5 mm/s; 150 µm slot at 85°C) to give a second PEDOT layer having a thickness of 30 ± 10 nm. After the device thus obtained was baked for 20 minutes at 140°C in nitrogen atmosphere, a 100 nm layer of silver was applied onto the second PEDOT layer via thermal evaporation (0.05-0.5 nm/s at 3 × 10⁻⁶ mbar) to give a tandem photovoltaic cell.

A single photovoltaic cell having the structure of ITO/TiO₂/ P3HT:PCBM/PEDOT/Ag was also prepared. The titanium oxide layer, the P3HT:PCBM layer, the PEDOT layer, and the silver layer were prepared using the same methods described in the preceding paragraph.

The tandem photovoltaic cell and single cell were tested for their properties. The open circuit voltage of both cells were measured at zero current using a Source Measurement Unit (SMU) Keithley 2400 when the device was illuminated by a solar simulator (Oriel) at 1 kW/m² Air Mass 1.5 global. The results show that the open circuit voltage of the tandem photovoltaic cell was 1.025 V, twice as much as that of a single photovoltaic cell having the structure of ITO/TiO₂/ P3HT:PCBM/ PEDOT/Ag.

Other embodiments are in the claims.

## Claims

1. A photovoltaic tandem cell system (100, 400), comprising:
first (110, 410) and second electrodes (170, 470);
a recombination layer (140, 440) between the first (110, 410) and second electrodes (170, 470), wherein
the recombination layer refers to a layer in a tandem cell where electrons generated from a first cell recombine with holes generated from a second cell;
the recombination layer (140, 440) comprising a semiconductor material; and
a first photoactive layer (130, 430) between the first electrode (110, 410) and the recombination layer (140, 440); and
a second photoactive layer (150, 450) between the second electrode (170, 470) and the recombination layer (140, 440);
**characterized in that**
the recombination layer (140, 440) comprises two layers (442, 444), one layer (444) comprising a p-type semiconductor material and the other layer (442) comprising an n-type semiconductor material;
wherein the p-type semiconductor material comprises a polymer selected from the group consisting of polythiophenes, polyanilines, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxalines, polybenzoisothiazoles, polybenzothiazoles, polythienothiophenes, poly(thienothiophene oxide)s, polydithienothiophenes, poly(dithienothiophene oxide)s, polytetrahydroisoindoles, and copolymers thereof; and
wherein the n-type semiconductor material comprises a metal oxide.

2. The photovoltaic tandem cell system of claim 1, wherein the n-type semiconductor material comprises a material selected from the group consisting of fullerenes, inorganic nanoparticles, oxadiazoles, discotic liquid crystals, carbon nanorods, inorganic nanorods, polymers containing CN groups, polymers containing CF3 groups, and combinations thereof.

3. The photovoltaic tandem cell system of claim 1 or 2, wherein the first (130, 430) or second photoactive layer (150, 450) comprises an electron donor material and an electron acceptor material.

4. The photovoltaic tandem cell system of any of claims 1 to 3, wherein the first photoactive layer (130, 430) has a first band gap and the second photoactive layer (150, 450) has a second band gap different from the first band gap.

5. The photovoltaic tandem cell system of any of claims 1 to 4, further comprising a hole carrier layer (120, 420) between the first photoactive layer (130, 430) and the first electrode (110, 410).

6. The photovoltaic tandem cell system of any of claims 1 to 5, further comprising a hole blocking layer (160, 460) between the second photoactive layer (150, 450) and the second electrode (170, 470).

7. A method, comprising:
preparing a photovoltaic tandem cell system (100, 400) according to one of the claims 1 to 6 having a recombination layer (140, 440) by a roll-to-roll process.

8. The method of claim 7, wherein the method further comprising disposing the recombination layer (140, 440) onto a photoactive layer (130, 430).

9. The method of claim 8, wherein the disposing comprises disposing a first layer (442) containing a first semiconductor material onto the photo active layer (430) and disposing a second layer (444) containing a second semiconductor material onto the first layer (442), the second semiconductor being different from the first semiconductor.

10. The method of claim 9, wherein one of the first and second semiconductor materials is an n-type semiconductor material and the other of the first and second semiconductor materials is a p-type semiconductor material.

11. The method of any of claims 8 to 10, wherein the recombination layer (140, 440) is disposed on the photoactive layer (130, 430) using at least one process selected from the group consisting of solution coating, ink jet printing, spin coating, dip coating, knife coating, bar coating, spray coating, roller coating, slot coating, gravure coating, and screen printing.

## Patentansprüche

1. Photovoltaisches Tandemzellensystem (100, 400), umfassend:
erste (110, 410) und zweite Elektrode (170, 470);
eine Rekombinationsschicht (140, 440) zwischen der ersten (110, 410) und
zweiten Elektrode (170, 470), wobei
die Rekombinationsschicht sich auf eine Schicht in einer Tandemzelle bezieht, wo Elektronen, die von einer ersten Zelle erzeugt wurden, mit Löchern, die von einer zweiten Zelle erzeugt wurden, rekombinieren;
die Rekombinationsschicht (140, 440) ein Halbleitermaterial umfasst; und
eine erste photoaktive Schicht (130, 430) zwischen der ersten Elektrode (110, 410) und der Rekombinationsschicht (140, 440); und
eine zweite photoaktive Schicht (150, 450) zwischen der zweiten Elektrode (170, 470) und der Rekombinationsschicht (140, 440);
**gekennzeichnet dadurch, dass**
die Rekombinationsschicht (140, 440) zwei Schichten (442, 444) umfasst,
wobei eine Schicht (444) ein p-Typ-Halbleitermaterial umfasst und die andere Schicht (442) ein n-Typ-Halbleitermaterial umfasst;
wobei das p-Typ-Halbleitermaterial ein Polymer umfasst, ausgewählt aus der Gruppe bestehend aus Polythiophenen, Polyanilinen, Polyvinylcarbazolen, Polyphenylenen, Polyphenylvinylenen, Polysilanen, Polythienylenvinylenen, Polyisothianaphtanen, Polycyclopentadithiophenen, Polysilacyclopentadithiophenen, Polycyclopentadithiazolen, Polythiazolothiazolen, Polythiazolen, Polybenzothiadiazolen, Poly(thiophenoxiden), Poly(cyclopentadithiophenoxiden), Polythiadiazolochinoxalinen, Polybenzoisothiazolen, Polybenzothiazolen, Polythienothiophenen, Poly(thienothiophenoxiden), Polydithienothiophenen, Poly(dithienothiophenoxiden), Polytetrahydroisoindolen und Copolymeren daraus; und
wobei das n-Typ-Halbleitermaterial ein Metalloxid umfasst.

2. Photovoltaisches Tandemzellensystem gemäß Anspruch 1, wobei das N-Typ-Halbleitermaterial ein Material umfasst ausgewählt aus der Gruppe bestehend aus Fullerenen, inorganischen Nanopartikeln, Oxadiazolen, diskoiden Flüssigkristallen, Kohlenstoffnanoröhrchen, inorganischen Nanoröhrchen, Polymeren, die CN-Gruppen enthalten, Polymeren, die CF3-Gruppen enthalten, und Kombinationen daraus.

3. Photovoltaisches Tandemzellensystem gemäß Anspruch 1 oder 2, wobei die erste (130, 430) oder zweite photoaktive Schicht (150, 450) ein Elektronendonatormaterial und ein Elektronenakzeptormaterial umfasst.

4. Photovoltaisches Tandemzellensystem gemäß einem der Ansprüche 1 bis 3, wobei die erste photoaktive Schicht (130, 430) eine erste Bandlücke und die zweite photoaktive Schicht (150, 450) eine zweite Bandlücke hat, die unterschiedlich von der ersten Bandlücke ist.

5. Photovoltaisches Tandemzellensystem gemäß einem der Ansprüche 1 bis 4, weiter umfassend eine Lochtransportschicht (120, 420) zwischen der ersten photoaktiven Schicht (130, 430) und der ersten Elektrode (110, 410).

6. Photovoltaisches Tandemzellensystem gemäß einem der Ansprüche 1 bis 5, weiter umfassend eine Lochblockierende-Schicht (160, 460) zwischen der zweiten Schicht (150, 450) und der zweiten Elektrode (170, 470).

7. Verfahren, umfassend:
Herstellen eines photovoltaischen Tandemzellensystems (100, 400) gemäß einem der Ansprüche 1 bis 6, das eine Rekombinationsschicht (140, 440) aufweist, durch einen Rolle-zu-Rolle-Prozess.

8. Verfahren gemäß Anspruch 7, wobei das Verfahren weiter Aufbringen der Rekombinationsschicht (140, 440) auf die photoaktive Schicht (130, 430) umfasst.

9. Verfahren gemäß Anspruch 8, wobei das Aufbringen Aufbringen einer ersten Schicht (442), die ein erstes Halbleitermaterial beinhaltet, auf die photoaktive Schicht (430) und Aufbringen einer zweiten Schicht, die ein zweites Halbleitermaterial beinhaltet, auf die erste Schicht (442) umfasst, wobei das zweite Halbleitermaterial unterschiedlich von dem ersten Halbleitermaterial ist.

10. Verfahren nach Anspruch 9, wobei eines der ersten und zweiten Halbleitermaterialien ein n-Typ-Halbleitermaterial und das andere der ersten und zweiten Halbleitermaterialien ein p-Typ-Halbleitermaterial ist.

11. Verfahren gemäß einem der Ansprüche 8 bis 10, wobei die Rekombinationsschicht (140, 440) auf die photoaktive Schicht (130, 430) aufgebracht ist unter Benutzung zumindest eines Prozesses ausgewählt aus der Gruppe bestehend aus Beschichtung aus einer Lösung, Tintenstrahldruck, Aufschleudern, Tauchbeschichtung, Rakeln, Bar-Coating, Sprühbeschichtung, Rollbeschichtung, Slot-Coating, Gravurstreichen und Screen-Druck.

## Revendications

1. Système de cellules photovoltaïques en tandem (100, 400), comprenant :
une première (110, 410) et une seconde électrode (170, 470) ;
une couche de recombinaison (140, 440) entre la première (110, 410) et la seconde électrode (170, 470), dans lequel
la couche de recombinaison se réfère à une couche dans une cellule en tandem dans laquelle des électrons générés depuis une première cellule se recombinent avec des trous générés depuis une seconde cellule ;
la couche de recombinaison (140, 440) comprenant un matériau semi-conducteur ; et
une première couche photoactive (130, 430) entre la première électrode (110, 410) et la couche de recombinaison (140, 440) ; et
une seconde couche photoactive (150, 450) entre la seconde électrode (170, 470) et la couche de recombinaison (140, 440) ;
**caractérisé en ce que**
la couche de recombinaison (140, 440) comprend deux couches (442, 444), une couche (44) comprenant un matériau semi-conducteur de type p et l'autre couche (442) comprenant un matériau semi-conducteur de type n;
dans lequel le matériau semi-conducteur de type p comprend un polymère choisi parmi le groupe constitué de polythiophènes, polyanilines, polyvinylcarbazoles, polyphénylènes, polyphényl-vinylènes, polysilanes, polythiénylène-vinylènes, polyisothiana-phthanènes, polycyclopentadithiophènes, polysilacyclopenta-dithiophènes, polycyclopentadithiazoles, polythiazolothiazoles, polythiazoles, polybenzothiadiazoles, poly(thiophène oxyde)s, poly(cyclopentadithiophène oxyde)s, polythiadiazoloquinoxalines, polybenzoisothiazoles, polybenzothiazoles, polythiénothiophènes, poly(thiénothiophène oxyde)s, polydithiénothiophènes, poly(dithiéno-thiophène oxyde)s, polytétrahydroisoindoles, et leurs copolymères ; et dans laquelle le matériau semi-conducteur de type n comprend un oxyde de métal.

2. Système de cellules photovoltaïques en tandem selon la revendication 1, dans lequel le matériau semi-conducteur de type n comprend un matériau choisi parmi le groupe constitué des fullerènes, nanoparticules inorganique, oxadiazoles, cristaux liquides discotiques, nanotiges de carbone, nanotiges inorganiques, polymères contenant des groupes CN, polymères contenant des groupes CF3, et leurs combinaison.

3. Système de cellules photovoltaïques en tandem selon la revendication 1 ou 2, dans lequel la première (130, 430) ou la seconde couche photoactive (150, 450) comprend un matériau donneur d'électrons et un matériau accepteur d'électrons.

4. Système de cellules photovoltaïques en tandem selon l'une quelconque des revendications 1 à 3, dans lequel la première couche photoactive (130, 430) présente un premier intervalle de bande et la seconde couche photoactive (150, 450) présente un second intervalle de bande différent du premier intervalle de bande.

5. Système de cellules photovoltaïques en tandem selon l'une quelconque des revendications 1 à 4, comprenant en outre une couche porteuse de trous (120, 420) entre la première couche photoactive (130, 430) et la première électrode (110, 410).

6. Système de cellules photovoltaïques en tandem selon l'une quelconque des revendications 1 à 5, comprenant en outre une couche de blocage de trous (160, 460) entre la seconde couche photoactive (150, 450) et la seconde électrode (170, 470).

7. Procédé, comprenant l'étape consistant à préparer un système de cellules photovoltaïques en tandem (100, 400) selon l'une des revendications 1 à 6 ayant une couche de recombinaison (140, 440) par un processus "roll-to-roll" (à bande guidée sur rouleaux).

8. Procédé selon la revendication 7, dans lequel le procédé comprend en outre l'étape consistant à disposer la couche de recombinaison de (140, 440) sur une couche photoactive (130, 430).

9. Procédé selon la revendication 8, dans lequel l'étape de disposition comprend de disposer une première couche (442) contenant un premier matériau semi-conducteur sur la couche photoactive (430), et de disposer une seconde couche (444) contenant un second matériau semi-conducteur sur la première couche (442), le second semi-conducteur étant différent du premier semi-conducteur.

10. Procédé selon la revendication 9, dans lequel un matériau parmi le premier et le second matériau semi-conducteur est un matériau semi-conducteur de type n, et l'autre matériau parmi le premier et le second matériau semi-conducteur est un matériau semi-conducteur de type p.

11. Procédé selon l'une quelconque des revendications 8 à 10, dans lequel la couche de recombinaison (140, 440) est disposée sur la couche photoactive (130, 430) en utilisant au moins un processus choisi parmi le groupe comprenant revêtement en solution, impression à jet d'encre, enduction centrifuge, revêtement au trempé, revêtement au couteau, revêtement au barreau, revêtement par pulvérisation, revêtement au rouleau, revêtement en fente, revêtement par gravure, et sérigraphie.
